(19) Europäisches Patentamt / European Patent Office / Office européen des brevets

(11) **EP 3 538 917 B1**

(12) **FASCICULE DE BREVET EUROPEEN**

(45) Date de publication et mention de la délivrance du brevet:
**13.10.2021 Bulletin 2021/41**

(21) Numéro de dépôt: **17801649.9**

(22) Date de dépôt: **10.11.2017**

(51) Int Cl.:
*G01S 7/02* *(2006.01)*

(86) Numéro de dépôt international:
**PCT/EP2017/078901**

(87) Numéro de publication internationale:
**WO 2018/087299 (17.05.2018 Gazette 2018/20)**

(54) **PROCÉDÉ DE CONTRÔLE DE LA COMPATIBILITÉ ÉLECTROMAGNÉTIQUE D'UN DÉTECTEUR DE RADARS AVEC AU MOINS UN ÉMETTEUR DE BORD DE SIGNAUX IMPULSIONNELS**

VERFAHREN ZUM TESTEN DER ELEKTROMAGNETISCHEN VERTRÄGLICHKEIT EINES RADARDETEKTORS MIT MINDESTENS EINEM IMPULSSIGNALGEBER AN BORD

METHOD FOR TESTING THE ELECTROMAGNETIC COMPATIBILITY OF A RADAR DETECTOR WITH AT LEAST ONE ONBOARD PULSE SIGNAL TRANSMITTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.11.2016 FR 1601604**

(43) Date de publication de la demande:
**18.09.2019 Bulletin 2019/38**

(73) Titulaire: **Thales**
**92400 Courbevoie (FR)**

(72) Inventeurs:
- **JAHAN, Daniel**
  **29200 Brest (FR)**
- **QUELLEC, Jean-Michel**
  **29200 Brest (FR)**
- **ARTIS, Jean-Paul**
  **29200 Brest (FR)**
- **CHRISTIEN, Daniel**
  **29238 Brest Cedex 2 (FR)**

(74) Mandataire: **Lavoix**
**2, place d'Estienne d'Orves**
**75441 Paris Cedex 09 (FR)**

(56) Documents cités:
JP-A- 2010 019 678  US-A1- 2010 135 443
US-B1- 6 727 840

- STEPHANE KEMKEMIAN ET AL: "Toward common radar & EW multifunction active arrays", PHASED ARRAY SYSTEMS AND TECHNOLOGY (ARRAY), 2010 IEEE INTERNATIONAL SYMPOSIUM ON, IEEE, PISCATAWAY, NJ, USA, 12 octobre 2010 (2010-10-12), pages 777-784, XP031828584, ISBN: 978-1-4244-5127-2

**Description**

L'invention concerne un procédé de contrôle de la compatibilité électromagnétique d'un détecteur de radars avec au moins un émetteur de bord de signaux impulsionnels. L'invention se rapporte également à un détecteur de radars et à une plate-forme associés.

Une plate-forme est une entité matérielle notamment utilisée dans le domaine militaire. Un navire, un aéronef, un véhicule terrestre, une station sol terrestre ou une station spatiale sont des exemples de telles plates-formes.

Les plates-formes sont équipées de détecteurs de radars et de radars de bord. Les détecteurs de radar ont pour rôle de recevoir et de détecter des signaux radar alors que les radars de bord émettent des signaux radar.

Dans certaines situations, le détecteur de radars reçoit des impulsions provenant des radars de bord.

De fait, l'étude de l'impulsion reçue par un détecteur de radars en provenance d'un radar de bord montre que l'impulsion reçue comprend une composante directe et des composantes réfléchies.

La composante directe est due à la propagation de l'impulsion émise entre l'antenne du radar et celle du détecteur de radars, selon le trajet le plus court. La composante directe arrive donc au niveau du détecteur de radars retardée par rapport à l'impulsion émise, mais en premier par rapport aux autres qui sont réfléchies.

Les composantes réfléchies sont dues aux réflexions de l'impulsion émise sur tous les objets matériels réflecteurs de l'environnement. Différents types d'objets réflecteurs sont à distinguer en fonction de leur proximité des acteurs (antenne du radar de bord et antenne du détecteur de radars). Dans l'ordre d'éloignement croissant, le premier type correspond aux surfaces réfléchissantes de la plate-forme porteuse en visibilité des acteurs (par exemple pour un navire, les superstructures, un canon), le type deuxième correspond à la surface terrestre (essentiellement la mer, voire la terre dans une certaine mesure) qui joue continûment jusqu'à l'horizon radioélectrique, et le troisième type correspond aux surfaces particulièrement réfléchissantes de dimension finie bornée dans la direction de propagation, formant ainsi des points singuliers (autres plates-formes que la plate-forme porteuse, relief terrestre).

Ainsi, la présence des radars de bord gêne donc le fonctionnement du détecteur de radars, que ce soit via la composante directe ou les composantes réfléchies de premier, deuxième ou troisième type.

Il est donc souhaitable que le fonctionnement des détecteurs de radars soit compatible avec les radars de bord. Une telle problématique est usuellement appelée compatibilité électromagnétique (abrégé par le sigle CEM).

Le brevet US6727840B1 décrit un procédé de suppression d'interférences pour un récepteur de caractérisation de signaux électromagnétiques.

Pour cela, il est connu d'utiliser une atténuation effective dans toute la bande de fréquence de réception du détecteur de radars. Une telle atténuation est, par exemple, réalisée par une diode PIN (de l'anglais *Positive Intrinsic Negative)* servant alors de commutateur.

Toutefois, une telle atténuation implique de couper toute la réception durant les phases de gêne, ce qui diminue la probabilité d'interception du détecteur de radars sur les signaux radar d'intérêt.

Il existe donc un besoin, dans le contexte d'une plate-forme équipée d'un détecteur de radars et d'au moins un émetteur de bord de signaux impulsionnels, pour un procédé de contrôle de la compatibilité électromagnétique ente le détecteur de radars et chaque émetteur de bord qui soit plus efficace.

Pour cela, la description décrit un procédé de contrôle de la compatibilité électromagnétique d'un détecteur de radars avec au moins un émetteur de bord de signaux impulsionnels, le détecteur de radars et chaque émetteur de bord appartenant à la même plate-forme, par élimination de la composante des échos extérieurs dans les signaux reçus par le détecteur de radars, le procédé comprenant une phase d'apprentissage comportant, pour chaque émetteur de bord une sous-phase d'acquisition visant à obtenir des impulsions détectées, chaque impulsion étant caractérisée par des caractéristiques, les caractéristiques comportant au moins la date d'arrivée de l'impulsion considérée et la fréquence porteuse de l'impulsion considérée. Le procédé comprend une sous-phase comportant l'acquisition de signaux issus des impulsions émises par l'émetteur de bord considéré et correspondant chacun à la composante des échos extérieurs, pour obtenir les impulsions détectées, et l'acquisition de mesures de caractéristiques des impulsions détectées, une sous-phase de calcul comportant la répartition des impulsions détectées en classes regroupant les impulsions pour lesquelles au moins deux caractéristiques présentent une plage de valeurs commune, et la sélection des classes comportant un nombre d'impulsions supérieur ou égal à un seuil prédéterminé, pour obtenir des classes sélectionnées, et une phase d'élimination comportant la construction d'un domaine d'élimination, un domaine d'élimination étant l'ensemble d'impulsions détectables par le détecteur de radars appartenant aux classes sélectionnées, et l'élimination dans les signaux reçus par le détecteur de radars (4) des impulsions appartenant au domaine d'élimination.

Suivant des modes de réalisation particuliers, le procédé comprend une ou plusieurs des caractéristiques suivantes, prise(s) isolément ou suivant toutes les combinaisons techniquement possibles :

- lors de chaque sous-phase de calcul, le nombre de caractéristiques est inférieur à 5.
- les caractéristiques comportent la largeur d'impulsion et la direction d'arrivée.
- chaque sous-phase de calcul comporte un regroupement de classes par utilisation d'un critère de distance entre deux classes.

- le détecteur de radars comporte un atténuateur, l'élimination est mise en œuvre par utilisation de l'atténuateur empêchant la détection d'impulsions appartenant au domaine d'élimination.
- le détecteur de radars comporte un calculateur, l'élimination étant mise en œuvre par le calculateur par élimination des impulsions détectées appartenant au domaine d'élimination.
- chaque émetteur de bord est propre à produire un signal de synchronisation, les phases d'apprentissage et d'élimination étant cadencées à l'aide du signal de synchronisation de chaque émetteur de bord.
- la sous-phase d'acquisition comporte la formation et l'utilisation de domaines d'acquisition.
- la sous-phase de calcul est mise en œuvre deux fois, la répartition lors de la première mise en œuvre de la sous-phase de calcul utilisant des premières caractéristiques, la répartition lors de la deuxième mise en œuvre de la sous-phase de calcul utilisant des deuxièmes caractéristiques, les premières et deuxièmes caractéristiques étant distinctes et les classes sélectionnées pour la phase d'élimination étant les classes sélectionnées lors de la première mise en œuvre de la sous-phase de calcul et les classes sélectionnées lors de la deuxième mise en œuvre de la sous-phase de calcul.

La description propose également un détecteur de radars comprenant un récepteur d'ondes électromagnétiques et un calculateur, le détecteur de radars étant configuré pour mettre en œuvre un procédé de contrôle de la compatibilité électromagnétique d'un détecteur de radars avec au moins un émetteur de bord de signaux impulsionnels, le détecteur de radars et chaque émetteur de bord appartenant à la même plate-forme, par élimination de la composante des échos extérieurs dans les signaux reçus par le détecteur de radars, le procédé comprenant une phase d'apprentissage comportant, pour chaque émetteur de bord une sous-phase d'acquisition visant à obtenir des impulsions détectées, chaque impulsion étant caractérisée par des caractéristiques, les caractéristiques comportant au moins la date d'arrivée de l'impulsion considérée et la fréquence porteuse de l'impulsion considérée, la sous-phase comportant l'acquisition de signaux issus des impulsions émises par l'émetteur de bord considéré et correspondant chacun à la composante des échos extérieurs pour obtenir les impulsions détectées, et l'acquisition de mesures de caractéristiques des impulsions détectées. Le procédé comprend une sous-phase de calcul comportant la répartition des impulsions détectées en classes regroupant les impulsions pour lesquelles au moins deux caractéristiques présentent une plage de valeurs commune, et la sélection des classes comportant un nombre d'impulsions supérieur ou égal à un seuil prédéterminé, pour obtenir des classes sélectionnées, et une phase d'élimination comportant la construction d'un domaine d'élimination, un domaine d'élimination étant l'ensemble d'impulsions détectables par le détecteur de radars appartenant aux classes sélectionnées, et l'élimination dans les signaux reçus par le détecteur de radars des impulsions appartenant au domaine d'élimination.

La description porte également sur également une plate-forme équipée d'un détecteur de radars tel que décrit précédemment.

D'autres caractéristiques et avantages de l'invention apparaîtront à la lecture de la description qui suit de modes de réalisation de l'invention, donnée à titre d'exemple uniquement et en référence aux dessins qui sont :

- figures 1 à 8, des représentations schématiques de signaux pour un premier cas ;
- figures 9 à 16, des représentations schématiques de signaux pour un deuxième cas ;
- figures 17 à 24, des représentations schématiques de signaux pour un troisième cas ;
- figure 25, une représentation schématique d'un exemple de détecteur de radars propre à mettre en œuvre un procédé de contrôle de la compatibilité électromagnétique entre des récepteurs de signaux impulsionnels et des émetteurs de bord de signaux impulsionnels, et
- figures 26 à 32, des représentations schématiques fonctionnels d'un exemple de mise en œuvre du procédé de contrôle à plusieurs stades distincts.

Il est proposé une plate-forme comportant une pluralité d'émetteurs de bord de signaux impulsionnels 2 et au moins un détecteur de radars 4.

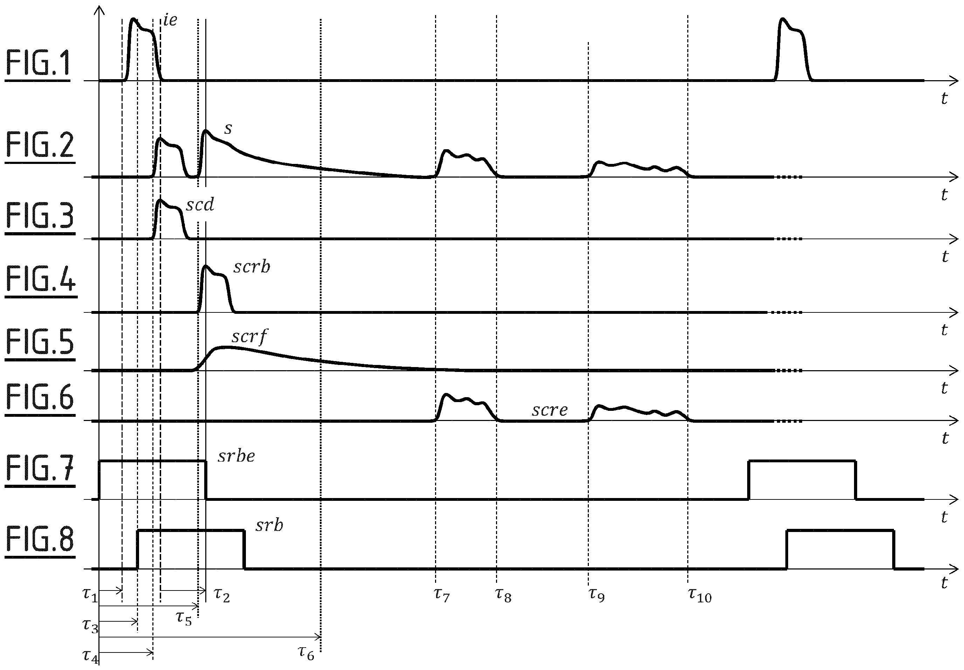

Avant de détailler les composants du détecteur de radars 4, il est décrit l'environnement perturbant dans lequel est amené à travailler le détecteur de radars 4 en référence aux figures 1 à 24.

La figure 1 représente l'enveloppe des impulsions émises désignées par *ie,* ces impulsions sont récurrentes.

La figure 2 représente l'enveloppe du signal reçu *s* par un détecteur de radars 4 à la suite de l'émission de l'impulsion *ie.*

Les figures 3 à 6 représentent les enveloppes des quatre composantes physiques formant le signal reçu *s.*

La figure 3 représente l'enveloppe de la composante directe, la composante directe étant désignée par *scd.*

La figure 4 représente l'enveloppe de la composante réfléchie par des éléments de la plate-forme porteuse. Une telle composante est appelée composante réfléchie de bord. La composante réfléchie de bord est désignée par le signe de référence *scrb.*

La figure 5 représente l'enveloppe de la composante réfléchie par la surface terrestre. Une telle composante est appelée le fouillis. Le fouillis est désigné par le signe de référence *serf.*

La figure 6 représente l'enveloppe de la composante réfléchie sur des objets isolés extérieurs. Du fait de la similitude avec les échos en radar, la composante réfléchie sur des objets isolés extérieurs est désigné par le signe de référence *scre.*

Dans la figure 6, à titre d'exemple, seuls deux échos sont illustrés.

La figure 7 représente un signal de synchronisation d'un radar de bord délivré par lui-même. Le signal de synchronisation est désigné par le signe de référence *srbe.*

Dans l'exemple présenté, le signal de synchronisation *srbe* recouvre temporellement l'impulsion émise *ie.* De ce fait, un premier intervalle de temps $\tau_1$ et un deuxième intervalle de temps $\tau_2$ peuvent être définis.

Le front avant du signal de synchronisation *srbe* est en avance d'un premier intervalle de temps $\tau_1$ par rapport à l'instant du début de l'impulsion émise *ie.*

Le front arrière du signal de synchronisation *srbe* est en retard d'un deuxième intervalle de temps $\tau_2$ par rapport à l'instant de fin de l'impulsion émise *ie.*

La figure 8 représente un signal correspondant au signal de synchronisation *srbe* qui arrive au niveau du détecteur de radars 4 après s'être propagé dans un câble de transmission. Le signal arrivant est désigné par le signe de référence *srb.*

Le signal transmis *srb* est retardé d'un troisième intervalle de temps $\tau_3$ par rapport au signal de synchronisation *srbe.*

Le quatrième intervalle de temps $\tau_4$ est défini comme le retard temporel entre le début du signal reçu *s* et le front avant du signal de synchronisation *srbe.*

Il est à noter que la différence entre les quatrième et troisième intervalles de temps $\tau_4 - \tau_3$ correspond au préavis que le front avant du signal transmis *srb* offre par rapport à la gène effective, il convient que ce préavis soit suffisamment grand et positif pour qu'il puisse être utilisé (typiquement au moins plusieurs centaines de nanosecondes).

Un cinquième intervalle de temps $\tau_5$ est défini comme l'intervalle de temps entre le front avant du signal de synchronisation *srbe* et la date d'arrivée la plus tardive des impulsions réfléchies par le bord de type *scrb.*

Un sixième intervalle de temps $\tau_6$ correspond à l'intervalle de temps entre le front avant du signal de synchronisation *srbe* et le passage du fouillis *serf* sous une puissance non perturbante.

Il est également défini un septième intervalle de temps $\tau_7$ et un huitième intervalle de temps $\tau_8$ correspondant respectivement aux instants de début et de fin du premier écho par rapport au front avant du signal de synchronisation *srbe.* Les neuvième et dixième intervalles de temps $\tau_9$ et $\tau_{10}$ correspondent aux mêmes instants pour le second écho.

Les figures 1 à 8 illustrent le cas où l'impulsion émise étant suffisamment courte (figure 1), il n'y a pas de recouvrement temporel entre la composante directe *sed* (figure 3) et la composante réfléchie de bord *scrb* (figure 4), faisant que le signal reçu *s* présente deux impulsions en début de récurrence (figure 2).

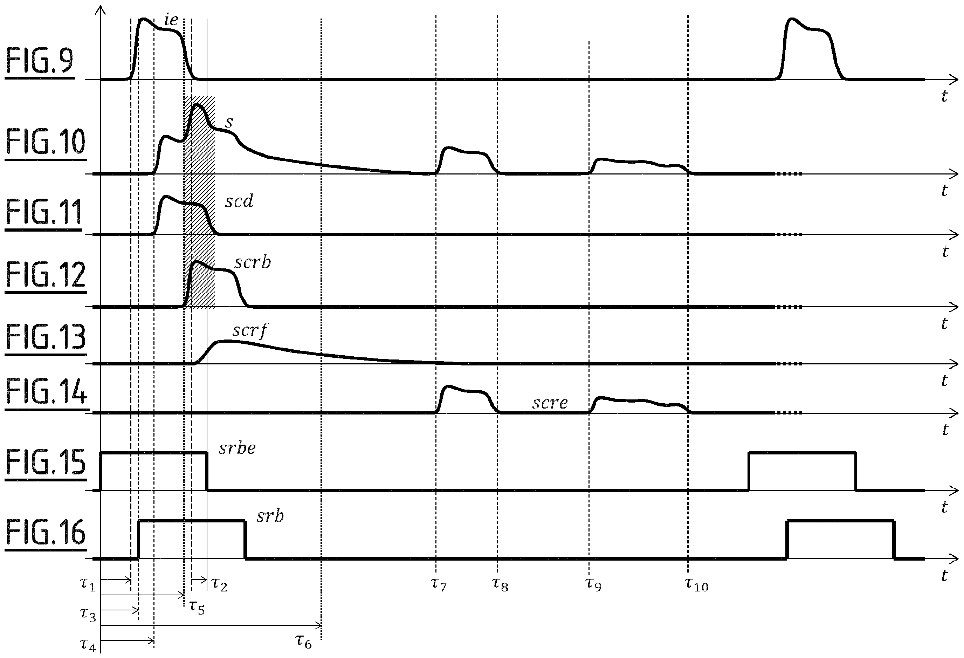

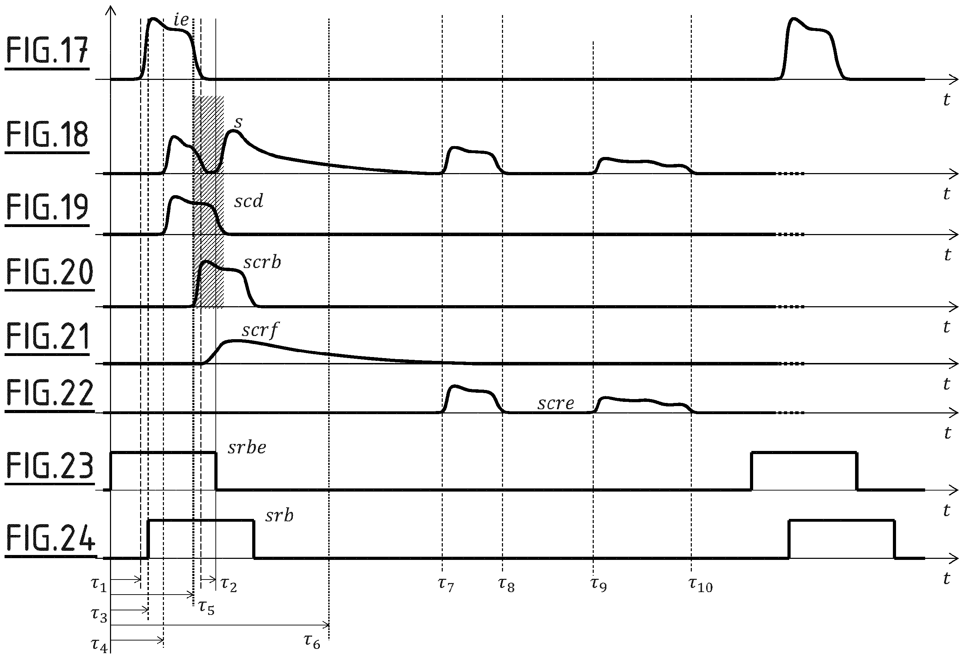

Les figures 9 à 24 illustrent le cas où les conditions sont telles qu'il y a ce recouvrement temporel matérialisé par la zone hachurée. Dans un tel cas, le détecteur de radars 4 perçoit la combinaison vectorielle de la composante directe *scd* et de la composante réfléchie de bord *scrb.* D'une façon générale, l'enveloppe résultante *s* est liée aux relations amplitude-phase entre ces deux signaux. Les figures 9 à16 illustrent une situation de ces deux signaux en phase et la figure 17 à 24 une situation en opposition. Ceci n'est qu'un exemple non limitatif car, en application, ces relations amplitude-phase ne sont ni connues, ni maîtrisées. De fait, dans certains cas, l'enveloppe présente une ou plusieurs impulsions successives. De plus, la situation se compliquer bien plus s'il y a plusieurs composantes réfléchies de bord.

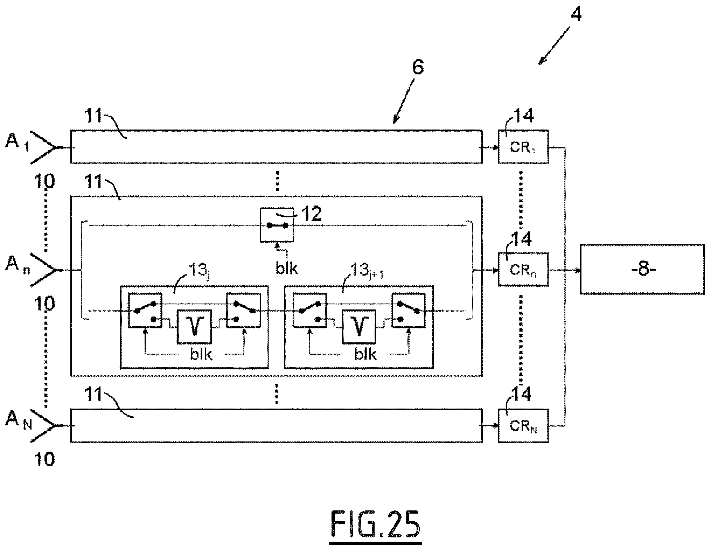

Un exemple de détecteur de radars 4 est représenté à la figure 25.

Le détecteur de radars 4 comporte deux parties : un récepteur 6 d'ondes radar et un calculateur 8.

Le récepteur 6 comporte N voies.

N est un nombre entier supérieur ou égal à 2 lorsque le récepteur 6 est propre à mettre en œuvre de la goniométrie.

Selon un autre mode de réalisation, le récepteur 6 comporte une seule voie.

Dans la figure 1, seules trois voies sont représentées : la première voie, la *n*-ième voie et la N-ième voie. La présence des autres voies est indiquée par des pointillés.

Chaque voie comporte une antenne 10 suivie par un atténuateur 11, l'atténuateur 11 étant suivi par une chaîne de réception 14.

Chaque antenne 10 est propre à recevoir un signal radioélectrique et à délivrer un signal électrique à l'atténuateur 11 à partir du signal radioélectrique reçu.

L'ensemble des antennes 10 permet la goniométrie des signaux reçus par les antennes.

L'atténuateur 11 comporte un ensemble d'éléments d'atténuation du signal.

La présence de l'atténuateur 11 permet d'assurer la compatibilité électromagnétique.

L'atténuateur 11 comporte au moins un commutateur 12.

Le commutateur 12 est propre à laisser passer un signal ou non.

Selon un exemple particulier, le commutateur 12 est une diode PIN contrôlée en polarisation par le signal de blanking et offrant une atténuation compris entre 40 à 60 dB.

Selon l'exemple de la figure 25, l'atténuateur 11 comporte *J* dispositifs d'insertion 13 d'un filtre réjecteur en série, chacun correspondant à la réjection d'une plage de fréquence appropriée vis-à-vis des radars de bord avec une atténuation de l'ordre de 30 à 60 dB.

Chaque chaîne de réception 14 est propre à délivrer un signal de sorte que l'ensemble des chaînes de réception 14 est propre à délivrer N signaux en parallèle.

Le calculateur 8 est, par exemple, un ensemble de composants numériques.

En variante, le calculateur 8 est un produit programme d'ordinateur, comme un logiciel.

Le calculateur 8 est propre à mettre en œuvre des étapes d'un procédé de contrôle de la compatibilité électromagnétique du récepteur 6 avec les émetteurs de bord de signaux impulsionnels 2.

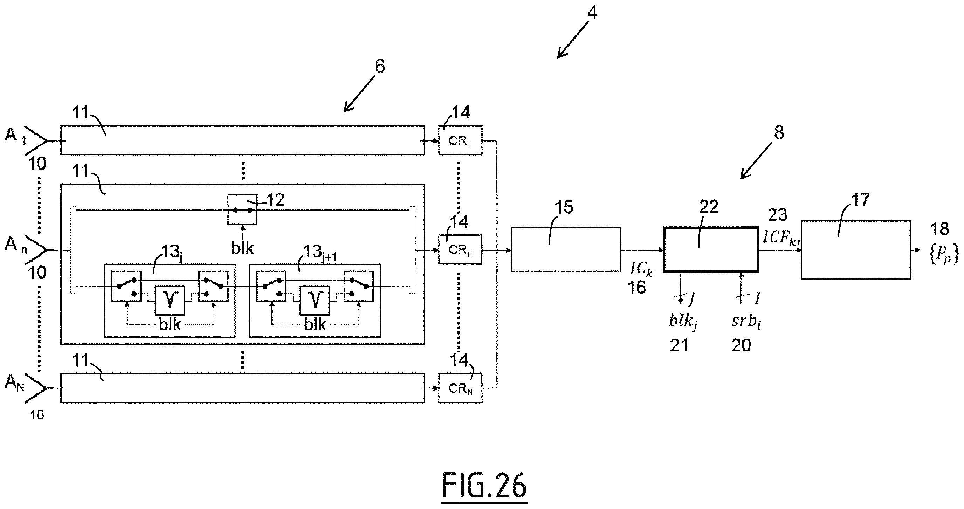

Le fonctionnement du détecteur de radars 4 est maintenant décrit en référence aux figures 26 à 32 qui présentent une vue schématique du procédé de contrôle à plusieurs étapes distinctes.

Pour cela, le calculateur 8 est décomposé en modules, cette décomposition illustrant les différentes fonctions que le calculateur 8 est propre à mettre en œuvre.

Le calculateur 8 comporte un module de caractérisation des impulsions 15, un module de caractérisation d'élaboration et de caractérisation des pistes 17 et un module de compatibilité 22 intercalé entre les deux modules 15 et 17.

Le module de caractérisation des impulsions 15 est propre à analyser les N signaux que le récepteur 6 est propre à délivrer.

Le module de caractérisation des impulsions 15 est propre à caractériser chaque impulsion radar incidente détectable.

Une telle caractérisation est mise en œuvre à l'aide d'au moins une mesure de grandeurs de l'impulsion.

Une grandeur est également appelée caractéristique dans ce qui suit (d'où le terme d'impulsions caractérisées).

Selon un exemple, la grandeur est la date d'arrivée de l'impulsion t, qui est l'instant d'arrivée datant le front avant de l'impulsion.

Selon un autre exemple, la grandeur est l'amplitude de l'impulsion A.

Selon encore un autre exemple, la grandeur est la largeur de l'impulsion *LI.*

Selon un autre mode de réalisation, la grandeur est la fréquence porteuse de l'impulsion *f.*

Selon encore un autre mode de réalisation, la grandeur est la modulation intra-impulsion intentionnelle *IMOP* (de l'anglais *Intentional Modulation On Pulse*) et éventuellement non intentionnelle *UMOP* (de l'anglais *Unintentional Modulation On Puise),* désignées globalement par la modulation intra-impulsion *MOP.*

Selon un autre exemple, la grandeur est la direction d'arrivée $\theta$. Par exemple, la direction d'arrivée est caractérisée par l'azimut, c'est-à-dire l'angle d'arrivée dans le plan horizontal local référencé par rapport au nord géographique. En variante, la direction d'arrivée est également caractérisée par le site, c'est-à-dire l'angle d'arrivée dans le plan vertical local par rapport à l'horizontale locale.

Selon un autre exemple, la grandeur est la polarisation de l'onde porteuse *pol.*

Selon un exemple particulier, la caractérisation est mise en œuvre à l'aide d'une pluralité de mesures de grandeurs de l'impulsion, chaque mesure étant choisie parmi les exemples précédents.

Pour la suite, il est supposé que les grandeurs choisies sont la date d'arrivée de l'impulsion *t,* l'amplitude de l'impulsion *A,* la largeur de l'impulsion *LI,* la fréquence porteuse de l'impulsion *f,* la modulation intra-impulsion *MOP* et la direction d'arrivée $\theta$.

En outre, pour la suite, chaque impulsion est désignée par le signe de référence $IC_k$. *k* étant un nombre entier, l'indice *k* correspondant à la *k*-ième impulsion radar détectée.

Pour la *k*-ième impulsion radar détectée, ces différentes grandeurs sont affectées d'un indice *k,* d'où l'écriture $IC_k = (t_k, A_k, LI_k, f_k, MOP_k, \theta_k)$.

Le module de compatibilité 22 est propre à mettre en œuvre le procédé de contrôle. Le procédé utilise les impulsions caractérisées $IC_k$ aussi désignées par le signe de référence 16 correspondant aux radars de bord, pour optimiser l'emploi de l'atténuateur 11 et pour pouvoir éliminer du flux $\{IC_k\}$ les impulsions caractérisées correspondant aux radars de bord et transmettre un flux d'impulsions caractérisées filtré $\{ICF_{k,}\}$ aussi désigné par le signe de référence 23 au module d'élaboration et de caractérisation des pistes 17.

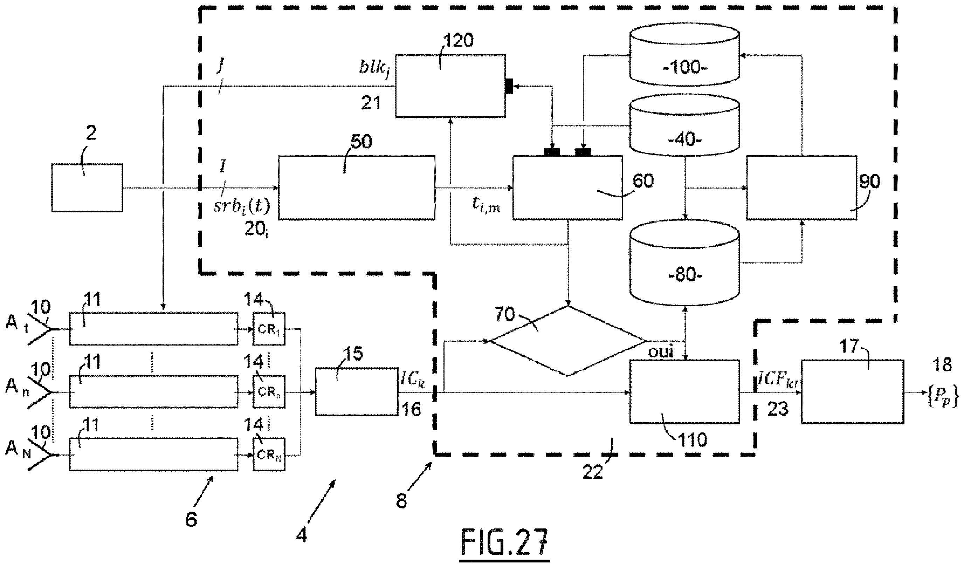

Pour cela, le module de compatibilité 22 comporte une pluralité de modules visibles en figure 27. Ces modules sont un module 40 de mémorisation de grandeurs prédéfinies, un module 50 de mesure de date d'arrivée, un module 60 de formation de domaines, un module 70 de comparaison d'une impulsion caractérisée avec un domaine, un module 80 de mémorisation des impulsions caractérisées recalées, un module 90 de calcul, un module 100 de mémorisation de grandeurs calculées, un module 110 d'élimination des impulsions caractérisées et un module 120 d'élaboration des blankings.

Le flux d'impulsions caractérisées $\{IC_k\}$ est traité par un module d'élaboration et de caractérisation des pistes 17, les pistes 18 étant des objets synthétisant l'ensemble des caractéristiques du radar perceptibles dans le temps (récurrence, rayonnement antennaire, modulations diverses).

Nous allons maintenant détailler en référence aux figures 27 à 32 le procédé de contrôle.

Le procédé comporte deux phases, à savoir une phase d'apprentissage et une phase d'élimination.

Les deux phases sont cadencées par les différents signaux de synchronisation des radars de bord.

La phase d'apprentissage a pour fonction d'acquérir une caractérisation fine des signaux issus des impulsions émises par les radars de bord grâce aux impulsions caractérisées $IC_k$ pour former des domaines d'élimination permettant de piloter précisément la phase d'élimination, les impulsions caractérisées $IC_k$ étant sélectionnées grâce à des domaines d'acquisition.

La phase d'apprentissage est mise en œuvre pour chaque radar de bord.

La phase d'apprentissage comporte trois sous-phases d'acquisition : une première sous-phase d'acquisition de la composante de bord (mélange de la composante directe *scd* et de la composante réfléchie de bord *scrb),* une deuxième sous-phase d'acquisition de la composante réfléchie de fouillis *serf* et une troisième sous-phase d'acquisition de la composante réfléchie sur des objets isolés extérieurs *scre.*

Chacune des trois sous-phases comprend une première étape d'acquisition d'impulsions caractérisées $IC_k$ et une seconde étape de calcul.

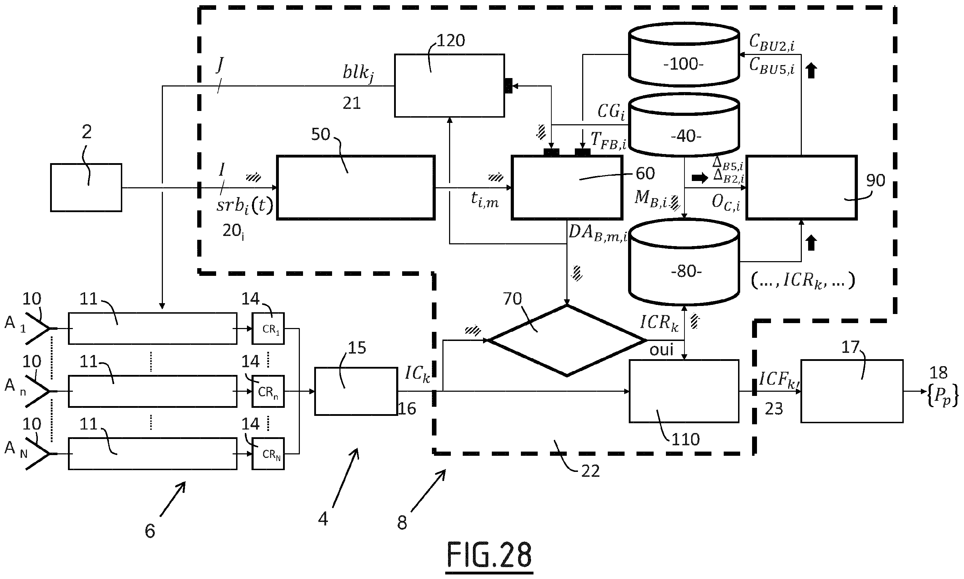

Les figures 28 à 30 correspondent respectivement aux trois sous-phases d'acquisition. Dans chacune des figures, apparaissent les fonctions utilisées en traits épais et les données utiles agrémentées d'une flèche, pour indiquer le cheminement, hachurée pour celles utilisées pour les premières étapes d'acquisition et noire pleine pour celles utilisées pour les secondes étapes de calcul.

Pour chaque radar de bord, chaque première étape d'acquisition est cadencée par le signal de synchronisation du radar de bord considéré $srb_i$.

Chaque première étape d'acquisition comporte une mesure, une formation et une comparaison.

Lors de la mesure, il est mesuré la date d'arrivée $t_{m,i}$ du front avant de la m-ième impulsion du signal de synchronisation $srb_i$ du i-ième radar de bord. Une telle mesure est mise en œuvre par le module de mesure de date d'arrivée 50, en cohérence avec les dates d'arrivée mesurées par le module de caractérisation des impulsions 15 situé en amont dans le détecteur de radars 4, c'est-à-dire avec les mêmes origine, résolution et précision de mesure de temps.

Lors de la formation, il est formé un domaine d'acquisition $DA_{m,i}$ propre à chaque sous-phase et correspondant à cette m-ième impulsion du signal de synchronisation $srb_i$ du i-ième radar de bord. La formation est mise en œuvre par le module de formation de domaines 60.

Lors de la comparaison, les impulsions caractérisées $IC_k$ incidentes sont comparées au domaine d'acquisition $DA_{m,i}$. La comparaison est mise en œuvre par le module de comparaison d'une impulsion caractérisée avec un domaine 70.

Si l'impulsion caractérisée $IC_k$ est contenue dans le domaine $DA_{m,i}$, alors l'impulsion est mémorisée par le module de mémorisation des impulsions caractérisées recalées 80, recalée en temps par rapport à la date d'arrivée de l'impulsion de synchronisation du radar de bord venant d'être mesurée, c'est-à-dire sous la forme $ICR_k = (\delta t_k, A_k, LI_k, f_k, MOP_k, \theta_k)$ où $\delta t_k = t_k - t_{m,i}$ sinon l'impulsion n'est pas utilisée.

Pour être représentatives en quantité, les impulsions caractérisées recalées $ICR_K$ correspondent à un nombre d'impulsions de synchronisation atteignant au moins $M_i$, valeur propre au i-ième radar de bord et mais aussi à chaque sous-phase.

La figure 28 illustre la première sous-phase d'acquisition de la composante de bord, $M_i = M_{B,i}$ une valeur prédéfinie par ailleurs et venant du module de mémorisation de grandeurs prédéfinies 40, et le domaine d'acquisition $DA_{m,i} = DA_{B,m,i}$ est formé par le module de formation de domaines 60 à partir, par exemple :

- d'un domaine de caractéristiques générales des impulsions du i-ième radar de bord, $CG_i$, le domaine étant prédéfini par ailleurs et venant du module de mémorisation de grandeurs prédéfinies 40, pouvant comprendre $Q_i$ classes de définition, $Q_i$ étant un nombre entier supérieur ou égal à 1, $CG_i = [..., CG_{i,q_i} ...]$ où $CG_{i,q_i} = [(LI_{min,i,q_i}, LI_{max,i,q_i}), (f_{min,i,q_i}, f_{max,i,q_i}), (MOP_{min,i,q_i}, MOP_{max,i,q_i})]$ et $q_i$ un nombre entier allant de 1 à $Q_i$ ;
- d'une durée $T_{FB,i}$ définissant une plage temps maximale relative à $t_{m,i}$ et durant laquelle les dates d'arrivée de la composante de bord peuvent être, et
- de la date d'arrivée du front avant de la m-ième impulsion du i-ième radar de bord $t_{m,i}$ venant du module de mesure de date d'arrivée 50.

Le domaine d'acquisition est calculé de la manière suivante :

$$DA_{B,m,i} = \left[ ..., \left[ \begin{array}{c} (t_{m,i}, t_{m,i} + T_{FB,i}), (LI_{min,i,q_i}, LI_{max,i,q_i}), \\ (f_{min,i,q_i}, f_{max,i,q_i}), (MOP_{min,i,q_i}, MOP_{max,i,q_i}) \end{array} \right], ... \right].$$

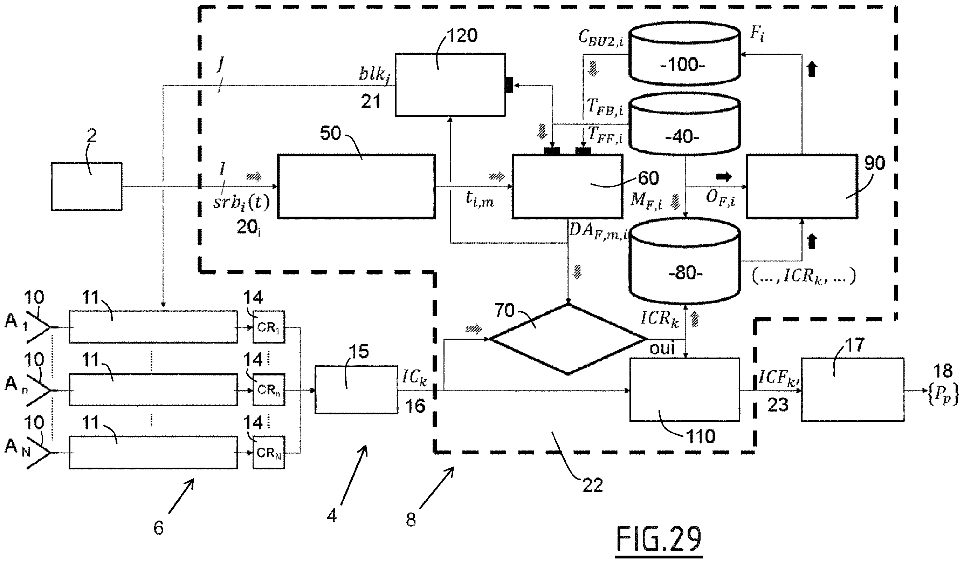

La figure 29 illustre la deuxième sous-phase d'acquisition, $M_i = M_{F,i}$ une valeur prédéfinie par ailleurs et venant du module de mémorisation de grandeurs prédéfinies 40, et le domaine d'acquisition $DA_{m,i} = DA_{F,m,i}$ est formée par le module de formation de domaines 60 à partir :

- de classes bord utiles $C_{BU2,i} = \left[ \dots, C_{BU2,i,l'_{2,i}}, \dots \right]$ où $C_{BU2,i,l'_{2,i}} = \left[ \left( \delta t_{min,i,l'_{2,i}}, \delta t_{max,i,l'_{2,i}} \right), \left( f_{min,i,l'_{2,i}}, f_{max,i,l'_{2,i}} \right) \right]$ avec $l'_{2,i}$ entier allant de 1 à $L'_{2,i}$, venant du module de mémorisation de grandeurs calculées 100 et établies par la seconde étape de calcul de la première sous-phase d'acquisition;
- des durées $T_{FB,i}$ et $T_{FF,i}$ définissant une plage temps maximale relative à $t_{m,i}$ et durant laquelle les dates d'arrivée de la composante fouillis peuvent être ;
- de la date d'arrivée du front avant de la m-ième impulsion du i-ième radar de bord $t_{m,i}$ venant du module de mesure de date d'arrivée 50.

Le domaine d'acquisition $DA_{F,m,i}$ est calculé de la manière suivante :

$$DA_{F,m,i} = \left[ \dots, \left[ \begin{array}{c} \left( t_{m,i} + \delta t_{min,i,l'_{2,i}} + T_{FB,i}, t_{m,i} + \delta t_{min,i,l'_{2,i}} + T_{FF,i} \right), \\ \left( f_{min,i,l'_{2,i}}, f_{max,i,l'_{2,i}} \right) \end{array} \right], \dots \right].$$

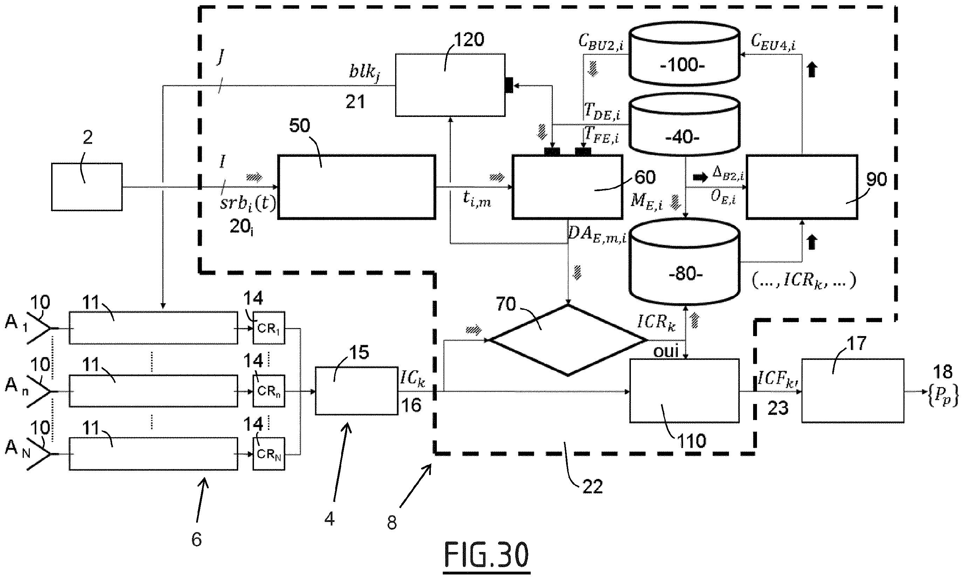

La figure 30 illustre la troisième sous-phase d'acquisition, $M_i = M_{E,i}$ une valeur prédéfinie par ailleurs et venant du module de mémorisation de grandeurs prédéfinies 40, et le domaine d'acquisition $DA_{m,i} = DA_{E,m,i}$ est formé par le module de formation de domaines 60 à partir :

- des classes bord utiles $C_{BU2,i} = \left[ \dots, C_{BU2,i,l'_{2,i}}, \dots \right]$ avec $C_{BU2,i,l'_{2,i}} = \left[ \left( \delta t_{min,i,l'_{2,i}}, \delta t_{max,i,l'_{2,i}} \right), \left( f_{min,i,l'_{2,i}}, f_{max,i,l'_{2,i}} \right) \right]$ et $l'_{2,i}$ entier allant de 1 à $L'_{2,i}$, où $L'_{2,i}$, venant du module de mémorisation de grandeurs calculées 100 et établies par la seconde étape de calcul de la première sous-phase d'acquisition
- des durées $T_{DE,i}$ et $T_{FE,i}$ définissant une plage temps maximale relative à $t_{m,i}$ et durant laquelle les dates d'arrivée de la composante échos extérieurs peuvent être ;
- de la date d'arrivée du front avant de la m-ième impulsion du i-ième radar de bord $t_{m,i}$ venant du module de mesure de date d'arrivée 50.

Le domaine d'acquisition $DA_{E,m,i}$ est calculé de la manière suivante :

$$DA_{E,m,i} = \left[ \dots, \left[ \begin{array}{c} \left( t_{m,i} + \delta t_{min,i,l'_{2,i}} + T_{DE,i}, t_{m,i} + \delta t_{min,i,l'_{2,i}} + T_{FE,i} \right), \\ \left( f_{min,i,l'_{2,i}}, f_{max,i,l'_{2,i}} \right) \end{array} \right], \dots \right].$$

Toutes les premières étapes d'acquisition s'arrêtent quand le nombre d'impulsions de synchronisation, pour le i-ième radar de bord, atteint $M_i$ une valeur spécifique à chaque sous-phase, l'ensemble des impulsions caractérisées recalées ainsi acquis $(\dots, ICR_k, \dots)$ est utilisé par la seconde étape de calcul de la sous-phase d'acquisition considérée.

Pour la première sous-phase d'acquisition, la seconde partie de calcul comprend une première répartition, une deuxième répartition, un regroupement et une détermination.

Lors de la première répartition, les impulsions caractérisées recalées $ICR_k$ de l'ensemble $(\dots, ICR_k, \dots)$ venant du module de mémorisation des impulsions caractérisées recalées 80 sont réparties en classes selon les cinq grandeurs $\delta t, A, LI, f$ et $MOP,$ délivrant un nombre d'impulsions caractérisées recalées $H_{BB5,i,l_{5,i}}$ par classes bord brutes

$$C_{BB5,i,l_{5,i}} = \left[ \begin{array}{c} \left( \delta t_{min,i,l_{5,i}}, \delta t_{max,i,l_{5,i}} \right), \left( A_{min,i,l_{5,i}}, A_{max,i,l_{5,i}} \right), \left( LI_{min,i,l_{5,i}}, LI_{max,i,l_{5,i}} \right), \\ \left( f_{min,i,l_{5,i}}, f_{max,i,l_{5,i}} \right), \left( MOP_{min,i,l_{5,i}}, MOP_{max,i,l_{5,i}} \right) \end{array} \right]$$

où $I_{5,i}$ est un nombre entier allant de 1 à $L_{5,i}$, $L_{5,i}$ étant le nombre de classes.

Cette première répartition correspond à un histogramme.

Lors de la seconde répartition, les impulsions caractérisées recalées $ICR_k$ de l'ensemble $(...,ICR_k,...)$ venant du module de mémorisation des impulsions caractérisées recalées 80 sont réparties en classes selon les deux grandeurs $\delta t$ et $f$, délivrant un nombre d'impulsions caractérisées recalées $H_{BB2,i,l2,i}$ par classe bord brute $C_{BB2,i,l2,i} = [(\delta t_{min,i,l5,i}, \delta t_{max,i,l5,i}), (f_{min,i,l5,i}, f_{max,i,l5,i})]$ où $I_{2,i}$ est un nombre entier allant de 1 à $L_{2,i}$, $L_{2,i}$ étant le nombre de classes.

Cette seconde répartition correspond à un histogramme.

Lors du regroupement, pour chacune des deux répartitions, des classes bord brutes trop proches sont regroupées.

Deux classes sont estimées trop proches si la distance entre centres de classe est inférieure à une valeur prédéfinie, $\Delta_{B5,i}$ et $\Delta_{B2,i}$ respectivement pour les première et seconde répartitions venant du module de mémorisation de grandeurs prédéfinies 40, dépendant des dispersions naturelles produites par le radar de bord et des dispersions de mesure du détecteur de radars 4 relativement à chaque grandeur définissant la classe.

Lors de la détermination, il est déterminé des classes bord utiles à partir des classes bord après regroupement pour chacune des deux répartitions, une classe utile étant une classe dont le nombre d'éléments est supérieur ou égal au seuil $O_{c,i}$ prédéfini venant du module de mémorisation de grandeurs prédéfinies 40.

Sont ainsi obtenues un premier jeu de classes bord utiles $C_{BU5,i}$ mémorisé dans le module de mémorisation de grandeurs calculées 100, comprenant $L'_{5,i}$ classes restant après regroupement et seuillage, chaque classes bord utiles étant définie par :

$$C_{BU5,i,l'_{5,i}} = \begin{bmatrix} \left(\delta t_{min,i,l'_{5,i}}, \delta t_{max,i,l'_{5,i}}\right), \left(A_{min,i,l'_{5,i}}, A_{max,i,l'_{5,i}}\right), \left(LI_{min,i,l'_{5,i}}, LI_{max,i,l'_{5,i}}\right), \\ \left(f_{min,i,l'_{5,i}}, f_{max,i,l'_{5,i}}\right), \left(MOP_{min,i,l'_{5,i}}, MOP_{max,i,l'_{5,i}}\right) \end{bmatrix}$$

où $l'_{5,i}$ est un nombre entier allant de 1 à $L'_{5,i}$, et un second jeu de classes bord utiles $C_{BU2}$ mémorisé dans le module de mémorisation de grandeurs calculées 100, comprenant $L'_{2,i}$ classes restant après regroupement et seuillage, chaque classe bord utile étant définie par $C_{BU2,i,l'_{2,i}} = \left[\left(\delta t_{min,i,l'_{2,i}}, \delta t_{max,i,l'_{2,i}}\right), \left(f_{min,i,l'_{2,i}}, f_{max,i,l'_{2,i}}\right)\right]$ où $l'_{2,i}$ est un nombre entier allant de 1 à $L'_{2,i}$ (pour mémoire, les indices et nombres affectés d'un prime « ' » sont ceux après regroupement et seuillage pour ne pas les confondre avec ceux avant cette tâche).

En variante, le nombre de cinq grandeurs, selon lesquelles les classes de la première répartition sont créées, est différent, en particulier plus faible.

Selon un autre exemple, n'avoir que la seconde répartition n'employant que les deux grandeurs indiquées est concevable.

Selon un autre exemple, l'élimination des classes par seuillage est faite avant le regroupement.

Pour la deuxième sous-phase d'acquisition de la composante réfléchie de fouillis, la seconde partie de calcul (figure 29) comprend une répartition et une recherche.

Lors de la répartition, les impulsions caractérisées recalées $ICR_k$ de l'ensemble $(...,ICR_k,...)$ venant du module de mémorisation des impulsions caractérisées recalées 80, sont réparties en classes selon les deux grandeurs $\delta t$ et $f$, délivrant un nombre d'impulsions caractérisées recalées $H_{F2,i,r2,i}$ par classes fouillis

$$C_{F2i,r_{2,i}} = \left[\left(\delta t_{min,i,r_{2,i}}, \delta t_{max,i,r_{2,i}}\right), \left(f_{min,i,r_{2,i}}, f_{max,i,r_{2,i}}\right)\right]$$

où $r_{2,i}$ est un nombre entier allant de 1 à $R_{2,i}$, $R_{2,i}$ étant le nombre de classes.

Cette répartition correspond à un histogramme.

En l'espèce, la nature continue du fouillis, en particulier du fouillis de mer, fait que le détecteur de radars 4 mesure une largeur d'impulsion égale à la valeur maximale pour laquelle le détecteur de radars 4 est conçu, et plusieurs fois de suite dans le temps tant que sa sensibilité lui permet de détecter ce fouillis. Ainsi la valeur de $LI$ est quasiment unique et les classes de retard $\delta t$ sont nombreuses et continues.

Lors de la recherche, des classes de retard ($\delta t_{min,i,r'_{2,i}}$, $\delta t_{max,i,r'_{2,i}}$) sont recherchées. Plus précisément, sont recherchées les classes de retard à partir desquelles les nombres $H_{F2,i,r'_{2,i}}$ à classe de fréquence constante ($f_{min,i,r_{2,i}}$, $f_{max,i,r_{2,i}}$) sont inférieurs à une valeur de seuil $O_{F,i}$ prédéfinie et venant du module de mémorisation de grandeurs prédéfinies 40, pour $r'_{2,i}$ entier allant de 1 à $R_{2,i}$ à $r_{2,i}$ entier constant quand $r'_{2,i}$ balaie l'ensemble des classes de retard, $r_{2,i}$ allant de 1 à $R_{2,i}$.

Il est ainsi obtenu un ensemble $F_i$ mémorisé dans le module de mémorisation de grandeurs calculées 100, de $R_{2,i}$ classes de fréquence ($f_{min,i,r_{2,i}}$, $f_{max,i,r_{2,i}}$) associées chacune à une classe de retard ($\delta t_{min,i,r'_{2,i}(r_{2,i})}$, $\delta t_{max,i,r'_{2,i}(r_{2,i})}$),

Où :

- $r_{2,i}$ est un nombre entier allant de 1 à $R_{2,i}$,
- 

$$F_i = \left( ..., \left[ \left( f_{min,i,r_{2,i}}, f_{max,i,r_{2,i}} \right), \left( \delta t_{min,i,r'_{2,i}(r_{2,i})}, \delta t_{max,i,r'_{2,i}(r_{2,i})} \right) \right], ... \right).$$

$F_i$ correspond à une carte de fouillis exprimant une présence de fouillis estimé gênant pour des classes de fréquence données en fonction de classes de retard, autrement dit en fonction de classes de distance données car, comme pour un radar, le retard multiplié par la moitié de la vitesse de propagation des ondes (150m/$\mu$s) fournit la distance.

Pour la troisième sous-phase d'acquisition de la composante réfléchie sur des objets isolés extérieurs, la seconde partie de calcul (figure 29) comprend une répartition, un regroupement et une détermination.

Lors de la répartition, les impulsions caractérisées recalées $ICR_k$ de l'ensemble (...,$ICR_k$,...) venant du module de mémorisation des impulsions caractérisées recalées 80, sont réparties en classes selon les quatre grandeurs $\delta t$, $LI$, $f$ et $\theta$, délivrant un nombre d'impulsions caractérisées recalées $H_{EB4,i,u_{4,i}}$ par classes échos extérieurs brutes

$$C_{EB4i,u_{4,i}} = \begin{bmatrix} \left( \delta t_{min,i,u_{4,i}}, \delta t_{max,i,u_{4,i}} \right), \left( LI_{min,i,u_{4,i}}, LI_{max,i,u_{4,i}} \right), \\ \left( f_{min,i,u_{4,i}}, f_{max,i,u_{4,i}} \right), \left( \theta_{min,i,u_{4,i}}, \theta_{max,i,u_{4,i}} \right) \end{bmatrix},$$

où $u_{4,i}$ est un nombre entier allant de 1 à $U_{4,i}$, $U_{4,i}$ étant le nombre de classes.

Cette répartition correspond à un histogramme.

Lors du regroupement, les classes échos extérieurs brutes trop proches sont regroupées. Deux classes sont estimées trop proches si la distance entre centres de classe est inférieure à une valeur prédéfinie par ailleurs, $\Delta_{E3,i}$ issue de 40, dépendant des dispersions naturelles produites par le radar de bord et des dispersions de mesure du détecteur de radars 4 relativement à chaque grandeur définissant la classe.

Lors de la détermination, sont regroupées les classes échos extérieurs utiles à partir des classes échos extérieurs après regroupement, une classe utile étant une classe dont le nombre d'éléments est supérieur ou égal au seuil $O_{ci}$ prédéfini par ailleurs et venant du module de mémorisation de grandeurs prédéfinies 40.

Il est ainsi obtenu un ensemble de classes utiles $C_{EU4,i}$ mémorisé dans le module de mémorisation de grandeurs calculées 100, comprenant $U'_{4,i}$ est le nombre de classes restant après regroupement et seuillage, chaque classe étant définie par :

$$C_{EU4,i,u'_{4,i}} = \begin{bmatrix} \left( \delta t_{min,i,u'_{4,i}}, \delta t_{max,i,u'_{4,i}} \right), \left( LI_{min,i,u'_{4,i}}, LI_{max,i,u'_{4,i}} \right), \\ \left( f_{min,i,u'_{4,i}}, f_{max,i,u'_{4,i}} \right), \left( \theta_{min,i,u'_{4,i}}, \theta_{max,i,u'_{4,i}} \right) \end{bmatrix}$$

où $u'_{4,i}$ est un entier allant de 1 à $U'_{4,i}$.

$C_{EU4,i}$ correspond à une carte des échos angle-distance à classe de fréquence et de largeur d'impulsion donnée, distance car, comme pour un radar, le retard multiplié par la moitié de la vitesse de propagation des ondes (150m/$\mu$s) fournit la distance.

En variante, l'élimination des classes par seuillage est mise en œuvre avant le regroupement.

La phase d'élimination a pour fonction d'éliminer les signaux issus des radars de bord en mettant en œuvre des domaines d'élimination, élaborés à partir des éléments appris par la phase d'apprentissage.

La phase d'élimination est mise en œuvre selon deux modes d'action différents, le mode d'action au niveau signal et le mode d'action au niveau impulsion caractérisée $IC_k$.

Le mode d'action au niveau signal agit par atténuation du signal grâce à l'atténuateur 11 commandés par un jeu de signaux de blanking approprié.

Le mode d'action au niveau impulsion caractérisée agit directement par élimination d'impulsions caractérisées (élimination de données).

Dans l'exemple présenté, la phase d'élimination utilise deux domaines d'élimination différents, un premier dédié à l'élimination des composantes de bord et de fouillis $DE_{BF,m,i}$ et un second dédié à l'élimination des composantes des échos extérieurs $DE_{EE,m,i}$.

Pour un même radar de bord, les deux domaines d'élimination sont établis généralement en parallèle sauf s'il n'y a pas matière à les produire en raison d'une absence de classes à l'issue de la phase d'apprentissage (par exemple, aucun écho extérieur détecté pour $DE_{EE,m,i}$).

Un domaine d'élimination donné n'est utilisé que par un seul mode d'action à la fois.

Les deux domaines d'élimination sont mis en œuvre indifféremment par le même mode d'action ou chacun par un mode d'action différent.

Selon un exemple particulier, le mode d'action au niveau signal est réservé aux composantes saturantes susceptibles de dégrader le fonctionnement du détecteur de radars 4, ce mode d'action est donc plutôt réservé au domaine d'élimination $DE_{BF,m,i}$.

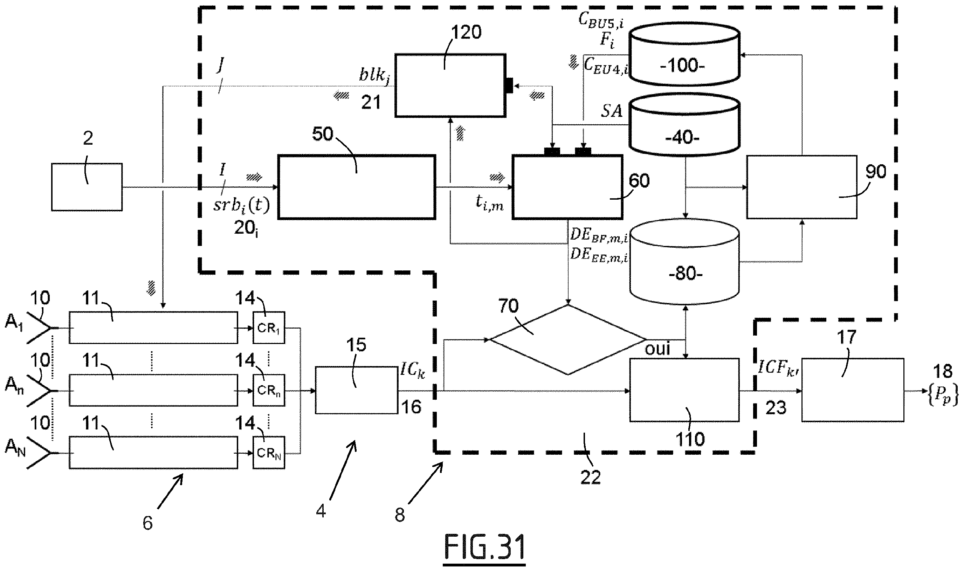

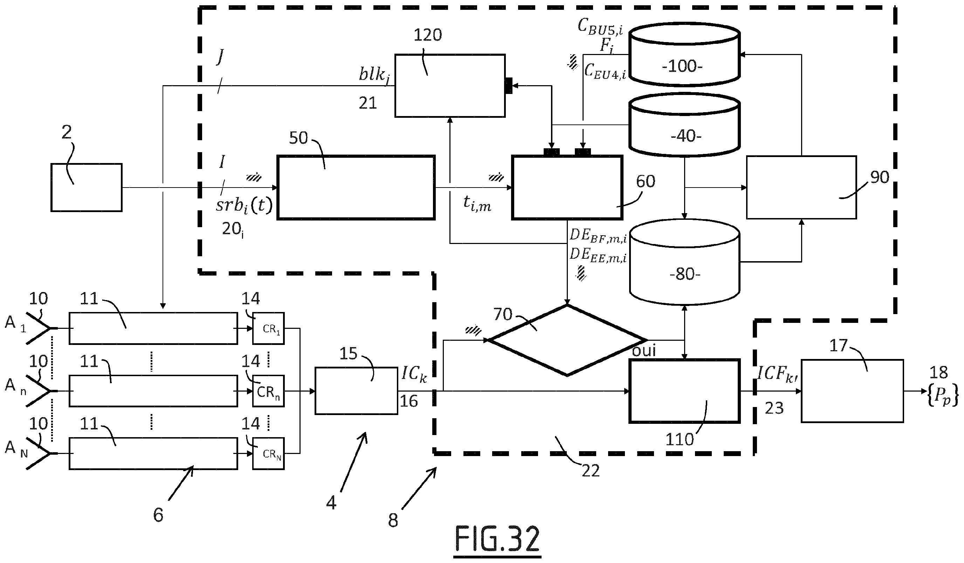

Les figures 31 et 32 illustrent respectivement le fonctionnement des modes d'action au niveau signal et au niveau impulsion caractérisée de la phase d'élimination. Dans chacune des figures 31 et 32, apparaissent les fonctions utilisées en traits épais et les données utiles agrémentées d'une flèche hachurée pour indiquer le cheminement.

Le domaine d'élimination dédié aux composantes de bord et de fouillis $DE_{BF,m,i}$ est formé par le module de formation de domaines 60 à partir de :

- l'ensemble $C_{BU5,i}$ de $L'_{5,i}$ classes et de l'ensemble $F_i$ de $R_{2,i}$ classes de fréquence ($f_{min,i,r2,i}$, $f_{max,i,r2,i}$), associées chacune à une classe de retard ( $\delta t_{min,i,r'_{2,i}(r_{2i})}$ , $\delta t_{max,i,r'_{2,i}(r_{2i})}$ ), $r_{2,i}$ allant de 1 à $R_{2,i}$, ces ensembles venant du module de mémorisation de grandeurs calculées 100 qui les a mémorisés de la phase d'apprentissage, et
- la date d'arrivée du front avant de la m-ième impulsion du i-ième radar de bord $t_{m,i}$ venant du module de mesure de date d'arrivée 50.

Par exemple, le domaine d'élimination est calculé de la façon suivante :

$$DE_{BF,m,i} =$$
$$\left[\ldots, \left[ \begin{array}{c} \left(t_{m,i} + \delta t_{min,i,l'_{5,i}}, t_{m,i} + \delta t_{max,i,l'_{5,i}}\right), \left(A_{min,i,l'_{5,i}}, A_{max,i,l'_{5,i}}\right), \\ \left(LI_{min,i,l'_{5,i}}, LI_{max,i,l'_{5,i}}\right), \left(f_{min,i,l'_{5,i}}, f_{max,i,l'_{5,i}}\right), \left(MOP_{min,i,l'_{5,i}}, MOP_{max,i,l'_{5,i}}\right) \end{array} \right], \ldots \right] +$$
$$\left[\ldots, \left[ \left(t_{m,i} + \delta t_{min,i,r'_{2,i}(r_{2,i})}, t_{m,i} + \delta t_{max,i,r'_{2,i}(r_{2,i})}\right), \left(f_{min,i,r_{2,i}}, f_{max,i,r_{2,i}}\right) \right], \ldots \right]$$

avec $l'_{5,i}$ allant de 1 à $L'_{5,i}$ et $r_{2,i}$ allant de 1 à $R_{2,i}$.

Le domaine d'élimination dédié aux composantes des échos extérieurs $DE_{EE,m,i}$ est formé par le module de formation de domaines 60 à partir de :

- l'ensemble $C_{EU4,i}$ de $U'_{4,i}$ classes venant du module de mémorisation de grandeurs calculées 100 qui l'a mémorisé lors de la phase d'apprentissage, et
- la date d'arrivée du front avant de la m-ième impulsion du i-ième radar de bord $t_{m,i}$ venant du module de mesure de date d'arrivée 50.

Par exemple, le domaine d'élimination est calculé de la façon suivante :

$$DE_{EE,m,i} = \left[ ..., \left[ \begin{array}{c} \left( t_{m,i} + \delta t_{min,i,u'_{4,i}}, t_{m,i} + \delta t_{max,i,u'_{4,i}} \right), \left( LI_{min,i,u'_{4,i}}, LI_{max,i,u'_{4,i}} \right), \\ \left( f_{min,i,u'_{4,i}}, f_{max,i,u'_{4,i}} \right), \left( \theta_{min,i,u'_{4,i}}, \theta_{max,i,u'_{4,i}} \right) \end{array} \right], ... \right]$$

avec $u'_{4,i}$ entier allant de 1 à $U'_{4,i}$ .

Pour chaque radar de bord, la phase d'élimination est cadencée par le signal de synchronisation du radar de bord considéré $srb_i$.

Pour les deux modes d'action, une première partie est identique, établissant à chaque impulsion de ce signal de synchronisation une mesure de la date d'arrivée $t_{m,i}$ du front avant de la m-ième impulsion du signal de synchronisation $srb_i$ du i-ième radar de bord est effectuée par le module de mesure de date d'arrivée 50, en cohérence avec les dates d'arrivée mesurées par le module de caractérisation des impulsions 15 situé en amont dans le détecteur de radars 4, c'est-à-dire avec les mêmes origine, résolution et précision de mesure de temps.

Il est également formé un domaine d'élimination $DE_{m,i}$ dépendant des composantes à éliminer et correspondant à cette m-ième impulsion du signal de synchronisation $srb_i$ du i-ième radar de bord est effectuée par le module de formation de domaine 60.

Pour le mode d'action au niveau signal, la première partie de la phase d'élimination est suivie, comme le montre la figure 31, d'une partie spécifique au mode avec le module d'élaboration des blankings 120, élaborant un ensemble de $J$ signaux de blanking $blk_j$ (21), $j$ étant un entier allant de 1 à $J$ et $J$ étant un entier supérieur ou égal à 1, apte à reproduire, pour un radar de bord donné, l'un des deux domaines d'élimination ou les deux selon le choix fait, et pour tous les radars de bord, l'ensemble des domaines d'élimination en vigueur formés par le module de formation de domaines 60 (première partie), en tenant compte de la définition SA de l'atténuateur 11, qui est un ensemble de données prédéfini par ailleurs et mémorisé dans le module de mémorisation de grandeurs prédéfinies 40.

Pour le mode d'action au niveau impulsion caractérisée $IC_k$, la première partie de la phase d'élimination est suivie, comme le montre la figure 32, d'une partie spécifique comprenant une comparaison et une élimination.

Lors de la comparaison, des impulsions caractérisées $IC_k$ incidentes sont comparées à l'ensemble des domaines d'élimination confiés pour l'ensemble des radars de bord, venant du module de formation de domaines 60 (première partie), c'est la même fonction que celle des sous-phases d'acquisition de la phase d'apprentissage.

Lors de l'élimination, l'impulsion caractérisée $IC_k$ du flux $\{IC_k\}$ est éliminée par le module d'élimination des impulsions caractérisées 110 si l'impulsion caractérisée $IC_k$ est contenue dans un quelconque domaine d'élimination, sinon, l'impulsion caractérisée $IC_k$ est laissée dans ce flux, le flux fourni au module d'élaboration et de caractérisation des pistes 17 est ainsi un flux filtré $\{ICF_k\}$.

Pour un radar de bord donné, la phase d'apprentissage est terminée pour commencer la phase d'élimination. Pour tenir compte des éventuelles évolutions dans le temps, de formes d'onde et d'emploi d'un radar de bord considéré, la phase d'apprentissage est relancée périodiquement pour obtenir un pilotage de la phase d'élimination actualisé. Dans un tel cas, la phase d'élimination au niveau du signal doit être arrêtée, sinon l'élimination en cours rendra les impulsions caractérisées recherchées, impossibles ou, au mieux, erronées.

D'une façon générale, lors d'une phase d'apprentissage sur un radar de bord donné, il convient d'arrêter les phases d'élimination au niveau signal concernant les autres radars de bord.

La phase d'élimination des impulsions caractérisées n'a pas d'influence sur la phase d'apprentissage. Un pilotage de la phase d'élimination des impulsions caractérisées, erroné car non actualisé, ne paraît pas gênant car l'arrêt de la phase ne fera pas mieux et l'élimination d'impulsions caractérisées désirées n'est pas plus probable qu'avec un pilotage non erroné.

Dans le contexte d'une plate-forme équipée d'un détecteur de radars 4 et d'au moins un émetteur de bord de signaux impulsionnels 2, le procédé assure une meilleure compatibilité électromagnétique entre le détecteur de radars 4 et chaque émetteur de bord 2.

Il est à noter que l'effet est toujours obtenu par mise en œuvre du procédé uniquement sur une des composantes, par exemple sur la composante de bord, la composante de fouillis ou la composante des échos extérieurs.

## Revendications

1. Procédé de contrôle de la compatibilité électromagnétique d'un détecteur de radars (4) avec au moins un émetteur de bord (2) de signaux impulsionnels, le détecteur de radars (4) et chaque émetteur de bord (2) appartenant à la même plate-forme, par élimination de la composante des échos extérieurs dans les signaux reçus par le détecteur de radars (4), le procédé comprenant :

- une phase d'apprentissage comportant, pour chaque émetteur de bord (2) :

   - une sous-phase d'acquisition visant à obtenir des impulsions détectées, chaque impulsion étant **caractérisée par** des caractéristiques, les caractéristiques comportant au moins la date d'arrivée de l'impulsion considérée et la fréquence porteuse de l'impulsion considérée, la sous-phase comportant :

      - l'acquisition de signaux issus des impulsions émises par l'émetteur de bord (2) considéré et correspondant chacun à la composante des échos extérieurs, pour obtenir les impulsions détectées, et
      - l'acquisition de mesures de caractéristiques des impulsions détectées,

   - une sous-phase de calcul comportant :

      - la répartition des impulsions détectées en classes regroupant les impulsions pour lesquelles au moins deux caractéristiques présentent une plage de valeurs commune, et
      - la sélection des classes comportant un nombre d'impulsions supérieur ou égal à un seuil prédéterminé, pour obtenir des classes sélectionnées, et

- une phase d'élimination comportant :

   - la construction d'un domaine d'élimination, un domaine d'élimination étant l'ensemble d'impulsions détectables par le détecteur de radars (4) appartenant aux classes sélectionnées, et
   - l'élimination dans les signaux reçus par le détecteur de radars (4) des impulsions appartenant au domaine d'élimination.

2. Procédé selon la revendication 1, dans lequel lors de chaque sous-phase de calcul, le nombre de caractéristiques est inférieur à 5.

3. Procédé selon la revendication 1 ou 2, dans lequel les caractéristiques comportent la largeur d'impulsion et la direction d'arrivée.

4. Procédé selon l'une quelconque des revendications 1 à 3, dans lequel, chaque sous-phase de calcul comporte un regroupement de classes par utilisation d'un critère de distance entre deux classes.

5. Procédé selon l'une quelconque des revendications 1 à 4, dans lequel le détecteur de radars (4) comporte un atténuateur (11), l'élimination est mise en œuvre par utilisation de l'atténuateur (11) empêchant la détection d'impulsions appartenant au domaine d'élimination.

6. Procédé selon l'une quelconque des revendications 1 à 4, dans lequel le détecteur de radars (4) comporte un calculateur (8), l'élimination étant mise en œuvre par le calculateur (8) par élimination des impulsions détectées appartenant au domaine d'élimination.

7. Procédé selon l'une quelconque des revendications 1 à 6, dans lequel chaque émetteur de bord (2) est propre à produire un signal de synchronisation, les phases d'apprentissage et d'élimination étant cadencées à l'aide du signal de synchronisation de chaque émetteur de bord (2).

8. Procédé selon l'une quelconque des revendications 1 à 7, dans lequel la sous-phase d'acquisition comporte la formation et l'utilisation de domaines d'acquisition.

9. Détecteur de radars (4) comprenant un récepteur (6) d'ondes électromagnétiques et un calculateur (8), le détecteur de radars (4) étant configuré pour mettre en œuvre un procédé de contrôle de la compatibilité électromagnétique d'un détecteur de radars (4) avec au moins un émetteur de bord (2) de signaux impulsionnels, le détecteur de radars (4) et chaque émetteur de bord (2) appartenant à la même plate-forme, par élimination de la composante des échos extérieurs dans les signaux reçus par le détecteur de radars (4), le procédé comprenant :

- une phase d'apprentissage comportant, pour chaque émetteur de bord (2) :

   - une sous-phase d'acquisition visant à obtenir des impulsions détectées, chaque impulsion étant **caractérisée par** des caractéristiques, les caractéristiques comportant au moins la date d'arrivée de l'impulsion considérée et la fréquence porteuse de l'impulsion considérée, la sous-phase comportant :

- l'acquisition de signaux issus des impulsions émises par l'émetteur de bord (2) considéré et correspondant chacun à la composante des échos extérieurs pour obtenir les impulsions détectées, et
- l'acquisition de mesures de caractéristiques des impulsions détectées,

- une sous-phase de calcul comportant :

- la répartition des impulsions détectées en classes regroupant les impulsions pour lesquelles au moins deux caractéristiques présentent une plage de valeurs commune, et
- la sélection des classes comportant un nombre d'impulsions supérieur ou égal à un seuil prédéterminé, pour obtenir des classes sélectionnées, et

- une phase d'élimination comportant :

- la construction d'un domaine d'élimination, un domaine d'élimination étant l'ensemble d'impulsions détectables par le détecteur de radars (4) appartenant aux classes sélectionnées, et
- l'élimination dans les signaux reçus par le détecteur de radars (4) des impulsions appartenant au domaine d'élimination.

10. Plate-forme équipée d'un détecteur de radars (4) selon la revendication 9.


**Patentansprüche**

1. Verfahren zur Überprüfung der elektromagnetischen Kompatibilität eines Radardetektors (4) mit mindestens einem bordseitigen Sender (2) von Impulssignalen, wobei der Radardetektor (4) und jeder bordseitige Sender (2) zur gleichen Plattform gehören, durch Eliminieren der Komponente von äußeren Echos in den von dem Radardetektor (4) empfangenen Signalen, wobei das Verfahren umfasst:

- eine Lernphase, die für jeden bordseitigen Sender (2) aufweist:

- eine Erfassungs-Teilphase, die darauf abzielt, detektierte Impulse zu erhalten, wobei jeder Impuls durch Merkmale gekennzeichnet ist, wobei die Merkmale mindestens das Ankunftsdatum des betreffenden Impulses und die Trägerfrequenz des betreffenden Impulses umfassen, wobei die Teilphase aufweist:

- Erfassen von Signalen aus den von dem betrachteten bordseitigen Sender (2) ausgesendeten Impulsen, die jeweils der Komponente von äußeren Echos entsprechen, um die detektierten Impulse zu erhalten, und
- Erfassen von Messungen von Merkmalen der detektierten Impulse,

- eine Berechnungs-Teilphase, die aufweist:

- Einteilen der detektierten Impulse in Klassen, die die Impulse zusammenfassen, für die mindestens zwei Merkmale einen gemeinsamen Wertebereich aufweisen, und
- Auswählen von Klassen, die eine Anzahl von Impulsen größer oder gleich einem vorgegebenen Schwellenwert aufweisen, um ausgewählte Klassen zu erhalten, und

- eine Eliminierungsphase, die aufweist:

- Konstruieren eines Eliminierungsbereichs, wobei ein Eliminierungsbereich die Gruppe von vom Radardetektor (4) detektierbaren Impulsen ist, die zu den ausgewählten Klassen gehören, und
- Eliminieren von Impulsen, die zum Eliminierungsbereich gehören, aus den vom Radardetektor (4) empfangenen Signalen.

2. Verfahren nach Anspruch 1, bei dem in jeder Teilphase der Berechnung die Anzahl der Merkmale weniger als 5 beträgt.

**3.** Verfahren nach Anspruch 1 oder 2, bei dem die Merkmale Impulsbreite und Ankunftsrichtung umfassen.

**4.** Verfahren nach einem beliebigen der Ansprüche 1 bis 3, bei dem jede Berechnungs-Teilphase eine Umgruppierung von Klassen unter Verwendung eines Abstandskriteriums zwischen zwei Klassen umfasst.

**5.** Verfahren nach einem beliebigen der Anspruch 1 bis 4, bei dem der Radardetektor (4) ein Dämpfungselement (11) umfasst, wobei das Eliminieren durch die Verwendung des Dämpfungselementes (11) ausgeführt wird, das das Detektieren von Impulsen, die zum Eliminierungsbereich gehören, verhindert.

**6.** Verfahren nach einem beliebigen der Ansprüche 1 bis 4, bei dem der Radardetektor (4) einen Rechner (8) aufweist, wobei das Eliminieren von dem Rechner (8) durch Eliminieren der detektierten Impulse, die zum Eliminierungsbereich gehören, ausgeführt wird.

**7.** Verfahren nach einem beliebigen der Ansprüche 1 bis 6, bei dem jeder bordseitige Sender (2) geeignet ist, ein Synchronisationssignal zu erzeugen, wobei die Lern- und Eliminierungsphasen mit Hilfe des Synchronisationssignals jedes bordseitigen Senders (2) getaktet werden.

**8.** Verfahren nach einem beliebigen der Ansprüche 1 bis 7, bei dem die Erfassungs-Teilphase das Bilden und das Verwenden von Erfassungsbereichen aufweist.

**9.** Radardetektor (4), der einen Empfänger (6) elektromagnetischer Wellen und einen Rechner (8) umfasst, wobei der Radardetektor (4) ausgebildet ist, ein Verfahren zur Überprüfung der elektromagnetischen Kompatibilität eines Radardetektors (4) mit mindestens einem bordseitigen Sender (2) von Impulssignalen durchzuführen, wobei der Radardetektor (4) und jeder bordseitige Sender (2) zur gleichen Plattform gehören, durch Eliminieren der Komponente von äußeren Echos in den vom Radardetektor (4) empfangenen Signalen, wobei das Verfahren umfasst:

- eine Lernphase, die für jeden bordseitigen Sender (2) aufweist:

- eine Erfassungs-Teilphase, die darauf abzielt, detektierte Impulse zu erhalten, wobei jeder Impuls durch Merkmale gekennzeichnet ist, wobei die Merkmale mindestens das Ankunftsdatum des betreffenden Impulses und die Trägerfrequenz des betreffenden Impulses umfassen, wobei die Teilphase aufweist:

- Erfassen von Signalen aus den von dem betrachteten bordseitigen Sender (2) ausgesendeten Impulsen, die jeweils der Komponente von äußeren Echos entsprechen, um die detektierten Impulse zu erhalten, und
- Erfassen von Messungen von Merkmalen der detektierten Impulse,

- eine Berechnungs-Teilphase, die aufweist:

- Einteilen der detektierten Impulse in Klassen, die die Impulse zusammenfassen, für die mindestens zwei Merkmale einen gemeinsamen Wertebereich aufweisen, und
- Auswählen von Klassen, die eine Anzahl von Impulsen größer oder gleich einem vorgegebenen Schwellenwert aufweisen, um ausgewählte Klassen zu erhalten, und

- eine Eliminierungsphase, die aufweist:

- Konstruieren eines Eliminierungsbereichs, wobei ein Eliminierungsbereich die Gruppe von vom Radardetektor (4) detektierbaren Impulsen ist, die zu den ausgewählten Klassen gehören, und
- Eliminieren von Impulsen, die zum Eliminierungsbereich gehören, aus den vom Radardetektor (4) empfangenen Signalen.

**10.** Mit einem Radardetektor (4) ausgestattete Plattform nach Anspruch 9.

**Claims**

**1.** A method for testing the electromagnetic compatibility of a radar detector (4) with at least one onboard pulse signal transmitter (2), the radar detector (4) and each onboard transmitter (2) belonging to the same platform, by eliminating the external echo component in the signals received by the radar detector (4), the method comprising:

- a training phase including, for each onboard transmitter (2):

- an acquisition subphase seeking to obtain detected pulses, each pulse being **characterized by** characteristics, the characteristics including at least the date of arrival of said pulse and the carrier frequency of said pulse, the subphase including:

- acquiring signals derived from pulses emitted by said onboard transmitter (2) and each corresponding to the external echo component, to obtain the detected pulses, and
- acquiring characteristic measurements of the detected pulses,

- a computing subphase including:

- distributing the detected pulses into classes grouping together the pulses for which at least two characteristics have a shared value range, and
- selecting classes including a number of pulses greater than or equal to a predetermined threshold, to obtain selected classes, and

- an elimination phase including:

- building an elimination range, an elimination range being the set of pulses detectable by the radar detector (4) belonging to the selected classes, and
- eliminating, in the signals received by the radar detector (4), pulses belonging to the elimination range.

2. The method according to claim 1, wherein during each calculation subphase, the number of characteristics is less than 5.

3. The method according to claim 1 or 2, wherein the characteristics include the pulse width and the direction of arrival.

4. The method according to any one of claims 1 to 3, wherein each calculating subphase includes a grouping of classes by using a distance criterion between two classes.

5. The method according to any one of claims 1 to 4, wherein the radar detector (4) includes an attenuator (11), the elimination is implemented by using the attenuator (11) preventing the detection of pulses belonging to the elimination range.

6. The method according to any one of claims 1 to 4, wherein the radar detector (4) includes a calculator (8), the elimination being implemented by the calculator (8) by eliminating detected pulses belonging to the elimination range.

7. The method according to any one of claims 1 to 6, wherein each onboard transmitter (2) is capable of producing a synchronization signal, the training and elimination phases being paced using the synchronization signal of each onboard transmitter (2).

8. The method according to any one of claims 1 to 7, wherein the acquisition subphase includes the formation and use of acquisition ranges.

9. A radar detector (4) comprising an electromagnetic wave receiver (6) and a calculator (8), the radar detector (4) being configured to carry out a method for testing the electromagnetic compatibility of a radar detector (4) with at least one onboard pulse signal transmitter (2), the radar detector (4) and each onboard transmitter (2) belonging to the same platform, by eliminating the external echo component in the signals received by the radar detector (4), the method comprising:

- a training phase including, for each onboard transmitter (2):

- an acquisition subphase seeking to obtain detected pulses, each pulse being **characterized by** characteristics, the characteristics including at least the date of arrival of said pulse and the carrier frequency of said pulse, the subphase including:

- acquiring signals derived from pulses emitted by said onboard transmitter (2) and each corresponding to the external echo component, to obtain the detected pulses, and
- acquiring characteristic measurements of the detected pulses,

- a computing subphase including:

- distributing the detected pulses into classes grouping together the pulses for which at least two characteristics have a shared value range, and
- selecting classes including a number of pulses greater than or equal to a predetermined threshold, to obtain selected classes, and

- an elimination phase including:

- building an elimination range, an elimination range being the set of pulses detectable by the radar detector (4) belonging to the selected classes, and
- eliminating, in the signals received by the radar detector (4), pulses belonging to the elimination range.

**10.** A platform equipped with a radar detector (4) according to claim 9.

FIG.1

*ie*

FIG.2

*s*

FIG.3

*scd*

FIG.4

*scrb*

FIG.5

*scrf*

FIG.6

*scre*

FIG.7

*srbe*

FIG.8

*srb*

$\tau_1$  $\tau_2$  $\tau_7$  $\tau_8$  $\tau_9$  $\tau_{10}$

$\tau_3$  $\tau_5$

$\tau_4$  $\tau_6$

EP 3 538 917 B1

FIG.9

FIG.10

FIG.11

FIG.12

FIG.13

FIG.14

FIG.15

FIG.16

*ie*

*s*

*scd*

*scrb*

*scrf*

*scre*

*srbe*

*srb*

$\tau_1$ $\tau_2$ $\tau_5$ $\tau_7$ $\tau_8$ $\tau_9$ $\tau_{10}$

$\tau_3$

$\tau_4$ $\tau_6$

EP 3 538 917 B1

FIG.17 *ie*

FIG.18 *s*

FIG.19 *scd*

FIG.20 *scrb*

FIG.21 *scrf*

FIG.22 *scre*

FIG.23 *srbe*

FIG.24 *srb*

$\tau_1$ $\tau_2$ $\tau_5$ $\tau_3$ $\tau_4$ $\tau_6$ $\tau_7$ $\tau_8$ $\tau_9$ $\tau_{10}$

EP 3 538 917 B1

**FIG.25**

FIG.26

EP 3 538 917 B1

FIG.27

FIG.28

FIG.29

FIG.30

FIG.31

FIG.32

**EP 3 538 917 B1**

**Documents brevets cités dans la description**

- US 6727840 B1